# EUROPÄISCHE PATENTSCHRIFT

(11) **EP 2 268 847 B1**
(45) Veröffentlichungstag und Bekanntmachung des Hinweises auf die Patenterteilung: **22.02.2012**
(21) Anmeldenummer: 09727706.5
(22) Anmeldetag: 14.03.2009
(51) Int. Cl.: C23C 16/08, C23C 16/18, C23C 16/448, C23C 16/30, C23C 16/455, C23C 16/52

(54) **CHEMISCHES DAMPFABSCHEIDE-VERFAHREN UNTER ATMOSPHÄRENDRUCK ZUR HERSTELLUNG EINER N-HALBLEITENDEN METALLSULFID-DÜNNSCHICHT**
ATMOSPHERIC PRESSURE CHEMICAL VAPOUR DEPOSITION METHOD FOR PRODUCING A N-SEMICONDUCTIVE METAL SULPHIDE THIN LAYER
PROCÉDÉ DE DÉPÔT CHIMIQUE EN PHASE VAPEUR À LA PRESSION ATMOSPHÉRIQUE POUR PRODUIRE UNE COUCHE MINCE DE SULFURE MÉTALLIQUE SEMICONDUCTRICE N

(30) Priorität: 01.04.2008 DE 102008017076
(43) Veröffentlichungstag der Anmeldung: 05.01.2011
(73) Patentinhaber: Helmholtz-Zentrum Berlin für Materialien und Energie GmbH, 14109 Berlin (DE)
(72) Erfinder: ALLSOP, Nicholas, 10243 Berlin (DE); FISCHER, Christian-Herbert, 14169 Berlin (DE); GLEDHILL, Sophie, 10551 Berlin (DE); LUX-STEINER, Martha Christina, 14163 Berlin (DE)
(86) Internationale Anmeldenummer: PCT/DE2009/000361
(87) Internationale Veröffentlichungsnummer: WO 2009/121322

(56) Entgegenhaltungen:
- WO-A-97/32056
- US-A1- 2008 012 015
- SPIERING S ET AL: "CD-free Cu(In,Ga)Se2 thin-film solar modules with In2S3 buffer layer by ALCVD" THIN SOLID FILMS, ELSEVIER-SEQUOIA S.A. LAUSANNE, CH, Bd. 431-432, 1. Mai 2003 (2003-05-01), Seiten 359-363, XP004428667 ISSN: 0040-6090
- HEHEMANN D G ET AL: "Synthesis, characterization and decomposition studies of tris(N,N-dibenzyldithiocarbamato)indium(II I): chemical spray deposition of polycrystalline CuInS2 on copper films" MATERIALS SCIENCE AND ENGINEERING B, ELSEVIER SEQUOIA, LAUSANNE, CH, Bd. 116, Nr. 3, 15. Februar 2005 (2005-02-15), Seiten 381-389, XP025305054 ISSN: 0921-5107 [gefunden am 2005-02-15]
- O'BRIEN P ET AL: "Novel precursors for the growth of alpha-In2S3: trisdialkyldithiocarbamates of indium" THIN SOLID FILMS, ELSEVIER-SEQUOIA S.A. LAUSANNE, CH, Bd. 315, Nr. 1-2, 2. März 1998 (1998-03-02), Seiten 57-61, XP004147552 ISSN: 0040-6090
- ALLSOP N A ET AL: "Indium sulfide thin films deposited by the spray ion layer gas reaction technique" THIN SOLID FILMS, ELSEVIER-SEQUOIA S.A. LAUSANNE, CH, Bd. 513, Nr. 1-2, 14. August 2006 (2006-08-14), Seiten 52-56, XP025005814 ISSN: 0040-6090 [gefunden am 2006-08-14]

## Beschreibung

Die Erfindung bezieht sich auf ein chemisches Dampfabscheide-Verfahren unter Atmosphärendruck (APCVD) zur Herstellung einer n-halbleitenden Metallsulfid-Dünnschicht auf einem beheizten Substrat mit einem das Metall enthaltenden Precursor, Schwefelwasserstoff (H₂S) als reaktiven, gasförmigen Precursor und einem inerten Trägergasstrom.

Bei der chemischen Dampfabscheidung (Chemical Vapor Deposition CVD) wird an der erhitzten Oberfläche eines Substrates aufgrund einer chemischen Reaktion aus der Gasphase eine Feststoffkomponente abgeschieden. Eine besondere Eigenschaft des Verfahrens ist die konforme Schichtabscheidung. Im Unterschied zur klassischen physikalischen Dampfabscheidung (Physical Vapor Deposition PVD) ermöglicht die chemische Gasphasenabscheidung auch die Beschichtung von komplex dreidimensional geformten Oberflächen. So können z. B. feinste Vertiefungen in Wafern oder auch Hohlkörper auf ihrer Innenseite gleichmäßig beschichtet werden. Voraussetzung für eine Abscheidung aus der Gasphase ist, dass flüchtige Precursor-Verbindungen des Schichtmaterials existieren, die bei einer bestimmten Reaktionstemperatur die feste Schicht abscheiden. Um gegenüber konkurrierenden Gasphasen-Reaktionen die gewünschten Reaktionen an der Oberfläche zu fördern und damit die Bildung von festen Partikeln in der Gasphase zu vermeiden und um bei weniger flüchtigen Precursorn mehr Material in die Gasphase zu bekommen, werden Prozesse chemischer Gasphasenabscheidung zumeist bei reduziertem Druck betrieben (typisch: 0,01-10 hPa).

N-halbleitende Metallsulfid-Dünnschichten werden bevorzugt als Pufferschichten in Solarzellen zwischen Absorber- und Fensterschicht eingesetzt, wodurch sich eine deutliche Erhöhung des Wirkungsgrades erzielen lässt. Unter einer Pufferschicht ist eine Schicht mit höherer Bandlücke als die angrenzende halbleitende Absorberschicht zu verstehen. Die höhere Bandlücke kann dabei durch Legieren oder durch eine entsprechende Materialwahl erreicht werden. Durch bessere Grenzflächenzustände wird die Rekombination im Grenzflächenbereich des pn-Übergangs verringert und dadurch die offene Klemmenspannung erhöht. Die Pufferschicht soll auch das Bandalignment optimieren. Das CdS ist ein n-Typ Halbleiter und besitzt eine Bandlücke von 2,4 eV und absorbiert somit im UV- und im blauen Bereich des Sonnenspektrums. Die dabei generierten Elektron-Loch-Paare werden nicht über die Raumladungszone getrennt und tragen somit nicht zum Strom bei.

Zunehmend wird versucht, die toxische CdS-Schicht durch weniger toxische Materialien zu ersetzen. Dabei wird auch zunehmend das CVD-Verfahren in verschiedenen Varianten eingesetzt, was ebenfalls eine gute Abdeckung rauer Substrate ermöglicht. Insbesondere Indium(III)sulfid (In₂S₃) mit einer indirekten Bandlücke von 2 eV bis 2,2 eV, weshalb es als indirekter Halbleiter weniger Licht absorbiert als der direkte Halbleiter CdS, hat sehr gute Aussichten, das toxische CdS abzulösen, weshalb verschiedenste Herstellungsmöglichkeiten aus dem Stand der Technik bekannt sind. Eine Herstellung mit einem CVD-Verfahren ist aber bislang nicht bekannt, da die einzusetzenden Komponenten nach Kenntnis des Fachmanns dazu neigen, bereits in der Gasphase feste Reaktionsprodukte zu bilden, die dann zu inhomogenen Schichten mit einer schlechten Abdeckung auf dem Substrat führen.

### STAND DER TECHNIK

Allgemein ist aus dem Stand der Technik die Herstellung von In₂S₃-Schichten bereits mittels Direktverdampfung, Pulverphase mit reduzierender Atmosphäre und Glühen bei 500°C bis 800°C, CBD (Chemical Bath Deposition), PVD (Physical Vapor Deposition), ALCVD (Atomic Layer Vapor Deposition oder Atomic Layer Epitaxy ALE), CSP (Chemical Spray Pyrolysis), ILGAR (Ion Layer Gas Reaction) und AAMOCVD (Aerosol Assisted Metal Oxid Chemical Vapor Deposition) bekannt. Eine direkte Herstellung von In₂S₃-Schichten durch CVD ist dagegen nicht bekannt.

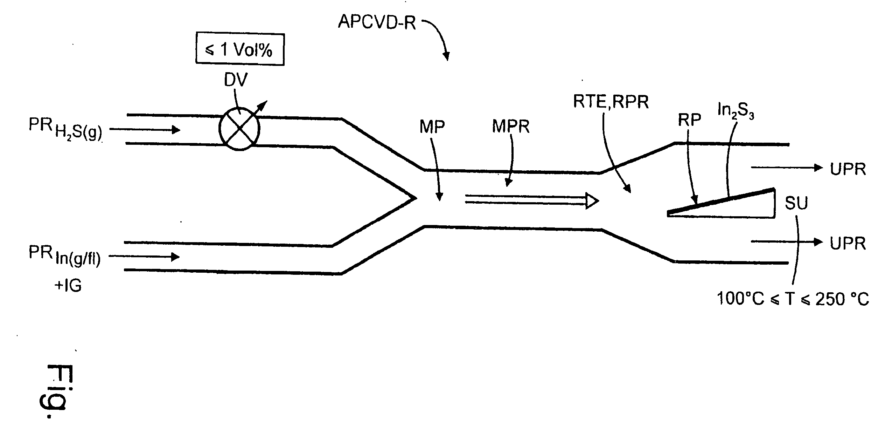

Eine Herstellung von für den Einsatz bei Solarzellen geeigneten verschiedenen Metallsulfidschichten, die auf einer Ionenaustauschreaktion beruht, ist aus der DE 198 31 214 C2 bekannt. Es wird das zweistufige ILGAR-Verfahren beschrieben, bei dem sequenziell zunächst als Ausgangsprodukt ein Metallsalz oder eine Metallverbindung auf einem auf eine Temperatur größer als 100°C aufgeheizten Substrat bevorzugt durch Tauchen oder Sprühen abgelagert und anschließend mit einem reaktiven Gas umgesetzt wird. Ein zweistufiger Prozess zur Herstellung von In₂S₃-Schichten zur Nutzung als Pufferschichten in Solarzellen durch Sprüh-ILGAR ist aus **ALLSOP 2006** bekannt. Hierbei wird zunächst eine InCl₃-Ethanol-Lösung auf das beheizte Substrat gesprüht, wo sich eine feste In(Cl,OH,O)-Precursor-Schicht ausbildet, die dann anschließend durch eine Begasung mit H₂S in eine Indiumsulfidschicht umgewandelt wird. Durch Wiederholungen des zweistufigen Zyklus kann die Schichtdicke eingestellt werden. Der Versuchsaufbau gemäß Figur 1 aus **ALLSOP 2006** zeigt das für das sequenzielle Sprüh-ILGAR-Verfahren mit einer Festphasenreaktion auf dem Substrat erforderliche Absperrventil in der H₂S-Zuführung. Ein Kontakt der gesprühten InCl₃-Ethanol-Lösung mit dem H₂S-Gas innerhalb des Reaktionsraums wird grundsätzlich unterbunden, da ansonsten eine absolut unerwünschte Teilchenbildung im Reaktorraum stattfinden würde. Aus diesem Grund wird jeweils zwischen den einzelnen Prozessschritten des Verfahrens immer wieder mit einem inerten Stickstoffgas gespült. Auch der Hinweis unter Kapitel 5 von **ALLSOP 2006,** dass beim Sprüh-ILGAR-Verfahren die Precursordeposition (In(Cl,OH)) im mikroskopischen Bereich Ähnlichkeiten mit dem CVD-Verfahren hat, gibt dem Fachmann jedoch noch keinen Hinweis darauf, wie er konkret vorgehen müsste, da im gleichen Absatz auf die Vorteile von Sprüh-ILGAR im makroskopischen Bereich und für die Deposition von In₂S₃ hingewiesen wird.

Ein spezielles CVD-Verfahren (Vapor Phase Epitaxy) unter Beteiligung von InCl₃ als Precursor ist aus **TAKAHASHI 1997** bekannt und wird unter Einsatz von reaktivem NH₃-Precursorgas zur Erzeugung von InN - welches nicht für Solarzellen eingesetzt wird - auf einem auf 750°C aufgeheizten Substrat genutzt. Aus **DIEHL 1975** ist es bekannt, In₂S₃ aufwachsen zu lassen unter einer Nutzung von halogenhaltigen Transportgasen. Ein Sprüh-Pyrolyse-Verfahren mit Ähnlichkeit zur CVD zur Erzeugung von InSnOx (als ITO-Schicht für Solarzellen) ist aus **SAWADA 2002** bekannt, wobei eine InCl₃-Ethanol-Lösung eingesetzt wird. Es wird jedoch kein reaktives Precursorgas und für Oxide naturgemäß auch kein H₂S eingesetzt, das Substrat wird auf Temperaturen von 300°C bis 350°C aufgeheizt. Aus **ERNITS 2007** ist ein Ultraschall-Sprüh-Pyrolyse-Verfahren (chemische Sprüh-Pyrolyse CSP) bekannt, bei dem eine InCl₃-Alkohol-Thioharnstoff-Lösung auf ein heißes Substrat (ca. 380°C) gesprüht wird, um In₂S₃ herzustellen. Dabei wird auf dem Substrat in situ aus dem Thioharnstoff H₂S-Gas gebildet. Dieses Verfahren wird zur Herstellung von Pufferschichten genutzt. Nachteilig bei Sprüh-Pyrolyse-Verfahren sind jedoch die hohe, für die Pyrolyse benötigte Temperatur und das Auftreten von Verunreinigungen, speziell von Oxiden. Bei niedrigen Temperaturen arbeitet die Sprüh-Pyrolyse nicht. Atomic Layer CVD (ALCVD, Atomic Layer Epitaxy ALE) zur Herstellung von In₂S₃ (für eine Herstellung von Pufferschichten) ist aus **ASIKAINEN 1994** bekannt. Dabei werden sequentiell bei 275°C verdampftes und an der auf 300°C bis 400°C aufgeheizten Substratoberfläche als Monolage adsorbiertes InCl₃ und H₂S-Gas eingesetzt. Aus **NAGHAVI 2003** ist ebenfalls ein sequentielles ALCVD-Verfahren für Solarzellen bekannt, bei dem bei 125°C verdampftes Indiumacetylacetonat In(acac)₃ und H₂S-Gas bei Substrattemperaturen von 160°C bis 260°C eingesetzt werden.

Ein Aerosolunterstütztes-CVD-Verfahren (Aerosol Assisted Metallorganic CVD - AAMOCVD) mit einem einzelnen, gesondert herzustellenden Precursor mit einem Schwefelanteil zur Erzeugung von In₂S₃ auf einem 425°C bis 475°C heißen Substrat ist aus **AFZAAL 2003** bekannt. Unter Anwendung der AACVD ist die Erzeugung von Zinnsulfid für photovoltaische Materialien aus **BARONE 2001** und **PARKIN 2001** bekannt. In Abhängigkeit von der Substrattemperatur wird bei Barone 2001 SnS (500°C), SnS₂ (350°C bis 450°C) und Sn₂S₃ (400°C) erzeugt. Dazu werden komplexe Precursorn, beispielsweise Zinnphenylschwefel, oder einfache Precursor, beispielsweise Zinnchlorid, und H₂S-Gas eingesetzt, welches bei einem schwefelhaltigen Precursor vornehmlich die Bildung von Oxiden verhindern soll, bei einem schwefelfreien Precursor an der Reaktion beteiligt ist.

Aus **MOLLOY 2001,** von der die vorliegende Erfindung als nächstliegendem Stand der Technik ausgeht, ist es bekannt, mittels chemischem Gasphasenabscheide-Verfahren unter Atmosphärendruck (APCVD) eine n-halbleitenden Zinnsulfid-Dünnschicht (Zinn(III)-Sulfid Sn₂S₃) auf einem auf eine Temperatur zwischen 475°C und 525°C aufgeheizten Substrat herzustellen. Dabei werden zwei Precursor, ein Zinn enthaltender löslicher Precursor (SnCl₄ (Flüssigkeit mit einem Siedepunkt von 114°C) oder SnBr₄) und Schwefelwasserstoff (H₂S) als reaktivem, gasförmigem Precursor, in einem inerten Stickstoff-Trägergasstrom eingesetzt. Die Reaktion von SnCl₄ oder SnBr₄ mit H₂S-Gas produzierte einphasige, einheitliche und übereinstimmende Schichten auf großen Glasplatten als Substrat. Dabei werden die Abscheideparameter Substrattemperatur, Precursor-Konzentration und Gasflussrate beobachtet. Es stellte sich heraus, dass die Substrattemperatur den größten Effekt auf die Synthese hatte (bei 475°C bis 525°C ergab sich braunes Sn₂S₃), wohingegen eine Variation der Flussrate des H₂S-Gases keinen Einfluss auf die Schichtstöchiometrie hatte. Bei einer unbegrenzten H₂S-Zufuhr ergab sich eine Proportionalität zwischen der Abscheiderate und der zugeführten Zinnprecursorrate. Eine Herstellung ohne das toxische H₂S-Gas, d.h. mit einer Schwefelzufuhr über den Feststoff-Precursor, ist nur unter Anwendung der AACVD möglich, da der Dampfdruck (Siedepunkt) der eingesetzten schwefelhaltigen Precursor für die APCVD zu gering ist. Weiterhin ist festzustellen, dass Sn ein anderes Reaktionsverhalten als In hat (andere Hauptgruppe), sodass der Fachmann nicht durch einfache Analogieschlüsse zu einer Herstellung von In₂S₃ durch APCVD gelangen kann.

### AUFGABENSTELLUNG

Die Aufgabe für die vorliegende Erfindung ist darin zu sehen, das eingangs beschriebene gattungsgemäße chemische Dampfabscheide-Verfahren unter Atmosphärendruck (APCVD) in seinen Verfahrensparametern so weiterzubilden, dass eine kompakte Indiumsulfid-Dünnschicht hergestellt werden kann, ohne dass der dem Fachmann bislang bekannte Nachteil auftritt, dass es bereits in der Gasphase zur einer Bildung fester Reaktionsprodukte kommt. Die erfindungsgemäße Lösung für diese Aufgabe ist dem Verfahrensanspruch zu entnehmen. Vorteilhafte Modifikationen des erfindungsgemäßen Verfahrens sind den Unteransprüchen zu entnehmen und werden im Folgenden im Zusammenhang mit der Erfindung näher erläutert.

Mit dem erfindungsgemäßen Verfahren ist es erstmals möglich, kompakte Indiumsulfid-Dünnschichten (In₂S₃) mit hoher Homogenität und damit Qualität, die sich besonders gut als Pufferschichten in Solarzellen einsetzen lassen und damit die toxischen CdS-Pufferschichten verdrängen, direkt mit dem einfachsten CVD-Verfahren, nämlich dem unter Atmosphärendruck, kostengünstig, schnell und reproduzierbar herzustellen. Es findet - zusätzlich zu einer einfachen Deposition des Indium enthaltenden Precursors mit Sulfurisierung an der Substratoberfläche - bereits hinter dem Mischpunkt eine Reaktion von H₂S mit der dem Indium enthaltenden Precursor entweder im Aerosoltröpfchen oder in der Gasphase statt, wodurch sich mehr In₂S₃ auf der Substratoberfläche ablagert. Dazu wird ein Indium enthaltender Precursor, der selbst einen hohen Dampfdruck besitzt oder mit einem Lösungsmittel ein flüchtiges Addukt bildet, zunächst in eine flüssige (Lösung und Überführung in ein Aerosol) oder gasförmige Phase überführt. In einem CVD-Reaktor wird dann der flüssige (als Aerosol) oder gasförmige, Indium enthaltende Precursor mit Schwefelwasserstoffgas und einem inerten Trägergasstrom gemischt. Es ergibt sich - je nach Aggregatzustand des Precursor-ein Mischungspunkt flüssig/gasförmig oder gasförmig/gasförmig. Bei beiden Mischungspunkten konnten hochwertige Indiumsulfidschichten erzeugt werden. Insbesondere die Möglichkeit der Mischung der beiden Precursor im flüssig/gasförmigen Mischungspunkt ist einerseits attraktiv, da Sprühmethoden verwendet werden können, andererseits aber überraschend, da eine Pulverbildung in der flüssigen/gasförmigen Phase erwartet würde. Für eine homogene Schichtbildung kann es für eine homogene Schichtbildung von Vorteil sein, wenn alle Komponenten in laminarer Strömung über das Substrat strömen.

Um zu verhindern, dass sich bereits im Reaktorinneren unerwünschte feste Reaktionskomponenten bilden, ist die Einstellung des Verhältnisses von eingesetztem Indium zu eingesetzten Schwefel und die Wahl der Substrattemperatur von ausschlaggebender Bedeutung. Im Gegensatz zu der in **MOLLOY 2007** gemachten Aussage, dass beim APCVD-Verfahren die Gasrate keinen Einfluss auf die Stöchiometrie hat und somit ein Überangebot an H₂S erzeugt werden kann, hat sich bei der Erfindung, die anstelle des Schwermetalls Zinn Sn aus der Kohlenstoffgruppe das Schwermetall Indium In aus der Borgruppe einsetzt, völlig überraschend gezeigt, dass hier der Anteil des zur Verfügung gestellten Schwefels einer der beiden Hauptparameter zur Erlangung einer hochwertigen Indiumsulfid-Dünnschicht darstellt. Deshalb wird bei der Erfindung die Zufuhr des Schwefelwasserstoffgases stets so geregelt, dass sich im Trägergasstrom eine Konzentration von Schwefel von gleich oder weniger als 1 Vol% einstellt. Im Gegensatz zu dem aus **MOLLOY 2007** bekannten Überangebot an Schwefel erfolgt bei der Erfindung somit nur ein äußerst knappes Schwefelangebot.

Neben dem Verfahrensparameter der H₂S-Konzentration bzw. der Schwefel-Konzentration bzw. des Verhältnisses von Indium zu H₂S ist der zweite wesentliche Verfahrensparameter zur Ausbildung homogener Schichten die Substrattemperatur. Allerdings zeigt sich bei **MOLLOY 2007** eine Erzeugung von Zinn(III)Sulfid (Sn₂S₃) erst bei Substrattemperaturen von 475°C bis 525°C. Bei der Erfindung hingegen konnte völlig überraschend eine bedeutsam niedrigere Substrattemperatur in einem Bereich gleich oder zwischen 100°C und 275°C eingestellt werden, um befriedigende Schichtergebnisse zu erhalten. Dies ist besonders wesentlich, da Solarzellenabsorber nach ihrer Herstellung nur noch Temperaturen bis ca. 275°C unbeschadet aushalten. Weiterhin stellte sich heraus, dass bereits bei der äußerst moderaten Temperatur von 100°C, die einen Einsatz von fast allen Substraten, insbesondere auch solchen aus Kunststoffen, Gläsern oder bei einer Beschichtung von Absorbermaterial als Substrat, die Herstellung einer Indiumsulfid-Dünnschicht nach der Erfindung möglich ist, ohne das Substrat negativ zu beeinflussen.

Bereits weiter oben wurde ausgeführt, dass bei der Erfindung die Möglichkeit besteht, den Indium enthaltenden Precursor im flüssigen Zustand (Flüssigkeitströpfchen in Luft = Aerosol) mit dem gasförmigen Precursor zu mischen ohne eine Pulverbildung zu erhalten. Vorteilhaft kann dabei der Indium enthaltende Precursor in eine flüssige Phase überführt werden durch Auflösen in einem Lösungsmittel und Zerstäubung der Lösung mit einem Ultraschallgenerator oder pneumatischem Zerstäuber zur Erzeugung eines Aerosols aus feinsten Tröpfchen. Alternativ kann der Indium enthaltende Precursor natürlich auch in eine gasförmige Phase überführt werden. Bevorzugt kann diese erfolgen durch Überleiten eines Lösungsmitteldampfes über den Indium enthaltenden festen Precursor. Beispielsweise werden Ethanoldämpfe durch Blubbern von Inertgas, beispielsweise N₂, durch Ethanol erzeugt und dann über festes InCl₃ geleitet. Als weitere Alternative kann die Überführung in die gasförmige Phase auch durch Auflösen in einem Lösungsmittel und Auftropfen der Suspension auf eine erwärmte Fläche erfolgen. Über die erwärmte Fläche strömt dann das Inertgas und leitet - wie vorher - den flüchtigen Precursor zur Vereinigung mit H₂S und auf das Substrat. In beiden Fällen bildet sich ein flüchtiges InCl₃-Ethanol-Addukt, das sich auf dem Substrat zu InCl₃ bzw. in Abhängigkeit von der Temperatur auch zu In(Cl, O, OH) zersetzt, abscheidet und hier zu In₂S₃ weiterreagiert. Parallel dazu kann in der Gasphase bzw. im Aerosol eine Reaktion mit H₂S zu schwefelhaltigen Zwischenprodukten erfolgen und zwar derart, dass keine festen Partikel entstehen. Diese Zwischenprodukte können an der Oberfläche zu In₂S₃ weiterreagieren. Auf der heißen Substratoberfläche erfolgt in jedem Fall die Abscheidung zu In₂S₃.

Weiterhin kann es sich bevorzugt bei dem Indium enthaltenden Precursor um ein Halogenidsalz des Indiums handeln. Zu Halogeniden (Halogenen, engl. Halid) zählen F, Cl, Br und Iod. Bevorzugt kann es sich bei dem Halogenidsalz um Indiumchlorid (InCl₃) handeln. Alternativ kann der Indium enthaltende Precursor auch ein β-Diketonat, bevorzugt Indium-Acetylacetonat (In(acac)₃) oder ein Abkömmling, sein. Weiterhin kann allgemein das Lösungsmittel ein Alkanol, bevorzugt Ethanol oder ein andere Alkohol, oder ein Keton, bevorzugt Aceton, sein. Schließlich wird bevorzugt ein Stickstoff-Trägerstrom (N₂) eingesetzt.

Einer der größten Vorteile der APCVD ist der Verfahrensablauf bei Atmosphärendruck (Umgebungsdruck). Dadurch sind keine abgeschlossenen Behältnisse und Vakuumpumpen erforderlich. Durchlaufsysteme können in einfacher Weise realisiert werden. Analog zum Umgebungsdruck herrscht bevorzugt in Reaktionsraum auch Umgebungstemperatur (Raumtemperatur). Die Zufuhr der Reaktionsenergie für die Bildung von In₂S₃ erfolgt durch die Erhitzung des Substrats und durch optionales Vorheizen der eingesetzten Precursor sowie des Trägergasstroms. Die folgenden chemischen Bruttoreaktionen laufen je nach o.g. Materialien ab (g = gasförmig, fl = flüssig, f = fest):

2 InCl_{3(g/fl)} + 3 H₂S_{(g)} ⇒ In₂S_{3(f)}+ 6 HCL_{(g)}

oder

2 In(acac)_{3(g/fl)} + 3 H₂S_{(g)} ⇒ In₂S_{3(f)} + 6 Hacac_{(g)}

Dabei können noch folgende Zwischenschritte ablaufen und entsprechende Zwischenprodukte auftreten (nicht stöchiometrisch):
1. InCl_{3(g/fl)} + EtOH → InₓX_{y}
2. InₓX_{y} + H₂S →InₓZ_{z} (Z enthält S)
3. InₓZ_{z} + Wärme → In₂S_{3(f)}

Eine moderate Vorheizung der Mischung aus dem Schwefelwasserstoff (H₂S) und dem Trägergasstrom beschleunigt die Reaktion und damit die Abscheide- bzw. Wachstumsrate. Die Einstellung von Raumtemperatur oder eine moderate Erwärmung der Precursorn außerhalb des Wirkungsbereiches des erhitzten Substrats sorgt dafür, dass keine vorzeitige Pulverbildung im Reaktionsraum eintritt.

### AUSFÜHRUNGSBEISPIEL

Ein Synthesebeispiel des Verfahrens nach der Erfindung wird nachfolgend zu deren weiterem Verständnis näher erläutert. Dazu zeigt die FIGUR eine schematische Prinzipskizze zum Ablauf des Verfahrens (Batch-Arbeitsweise, Inline-Arbeitsweise ebenfalls möglich).

In der **FIGUR** ist ein **CVD-**Reaktor **APCVD-R** dargestellt, der bei Atmosphärendruck arbeitet. Es wird ein erster Precursor **PR_{H2S(g)}** in Form von Schwefelwasserstoffgas H₂S und ein zweiter Precursor **PR_{ln(g/fl)},** der Indium In enthält und gasförmig oder flüssig (in Lösung) sein kann, eingesetzt. Weiterhin wird ein Inertgasstrom **IG** zugeführt, wobei der gezeigte Einspeiseort optional ist und auch an jeder anderen geeigneten Stelle liegen kann. Dabei wird die Gaszufuhr des gasförmigen Precursors **PR_{H2S(g)}** beispielsweise über ein Dosierventil **DV** so eingeregelt, dass eine absolute Konzentration von unter 1 Vol% nach dem Mischpunkt erreicht wird, wobei die Konzentration des Indium enthaltenden Precursors derart angepasst ist, das die herzustellende Indiumsulfidschicht besonders kompakt ist. Auch das Verhältnis von H₂S zu **PR_{In(g/fl)}** ist für die Schichtqualität entscheidend. Die Zufuhr des zweiten Precursors **PR_{In(g/fl)}** erfolgt mit einer optimalen Rate (beispielsweise 25 µM/min). Im Falle einer Vernebelung des zweiten Precursors **PR_{In(g/fl)}** kann dessen Konzentration durch optische Reflexionsmessung bestimmt werden. Bei einer Abweichung von der absoluten Schwefelwasserstoffkonzentration vom vorgegebenen Sollwert (≤ 1 Vol% im Mischgebiet **MP**) kann dann entsprechend nachgeregelt werden.

Die Abscheiderate wird von der Konzentration des gasförmigen Precursors **PR_{H2S(g)}** und von der Temperatur des Mischprecursors **MPR,** der sich im Mischgebiet **MP** von erstem Precursor **PR_{H2S(g)}** und zweitem Precursor **PR_{In(g/fl)}** bildet, bestimmt. Im Mischungsgebiet **MP** entsteht ein Mischprecusor **MPR.** Durch die gewählten Parameter (es herrschen Umgebungsdruck **RPR -** also Atmosphärendruck (der mittlere Luftdruck der Atmosphäre beträgt auf Meereshöhe 1013,25 mbar, Schwankungsbreite 869,9 mbar bis 1085,7 mbar) und Umgebungstemperatur **RTE** (Raumtemperatur, beispielsweise 18°C bis 22°C) erfolgt eine Reaktion zu schwefelhaltigen Zwischenprodukten, aber keine vorzeitige Reaktion zu In₂S₃ und damit Pulverbildung. Vielmehr wird der Mischprecursor **MPR** bis zu einem Substrat SU geführt, dessen Oberfläche auf eine Temperatur T zwischen 100°C und 275°C aufgeheizt worden ist. Auf dem Substrat **SU** bzw. unmittelbar darüber bildet sich somit ein Reaktionsgebiet **RP,** in dem sich die Zwischenprodukte zersetzen bzw. die beiden Precursor **PR_{H2S(g)}** und **PR_{In(g/fl)}** miteinander reagieren und zu einer Bildung der gewünschten homogenen Metallsulfidschicht auf dem Substrat **SU** führen. Nicht abgeschiedene Reaktionsprodukte **UPR** werden hinter dem Substrat **SU** abgeführt gesammelt und können recycelt werden.

### HERSTELLUNGSBEISPIEL FÜR EINE HOMOGENE, KOMPAKTE INDIUMSULFIDDÜNNSCHICHT

Indiumchlorid InCl₃ ist ein Feststoff mit einem geringen Dampfdruck, d.h. sehr hohem Schmelz- bzw. Siedepunkt (586°C). Um dies Material der APCVD zugänglich zu machen, ist die Umwandlung in ein flüchtigeres Addukt z.B. mit einem Alkohol nötig. InCl₃ wird deshalb zunächst in Ethanol (alternativ in Aceton, alternativ In(acac)₃ in Ethanol) gelöst (Konzentration 25 mM). 1 ml/min dieser Lösung wird dann vernebelt. Das entstehende Aerosol wird mit einem Stickstoff-Trägergasstrom mit einer Flussrate von 5 l/min transportiert und mit einem Gasstrom von 5% H₂S in Ar, welches mit einer Injektionsrate von 15 ml/min zugeführt wird, gemischt.

Es ergibt sich eine absolute H₂S-Konzentration von 0,015 Vol%, welche deutlich unter 1 Vol% liegt. Der Mischprecursor **MP** aus Trägergas **IG,** Aerosol (Indium enthaltender Precursor **PR_{In(g/fl)}** und Reaktivgas (gasförmiger Precursor **PR_{H2S(g)})** (und ggfs. schwefelhaltiger Zwischenprodukte) wird dann (ggfs. in laminarer Strömung) auf das geheizte Substrat **SU** geleitet, welches eine Temperatur **T** = 200°C aufweist. Auf dem geheizten Substrat **SU** bildet sich dann mit einer Aufwuchsrate von 9 nm/min eine kompakte Schicht aus Indiumsulfid In₂S₃ aus. Eine Schichtbildung wird auch bereits bei einer Temperatur T des Substrats **SU** = 100°C erreicht. Hier beträgt die Wachstumsrate dann allerdings nur 2 nm/min. Bei der Herstellung ist die Umgebungstemperatur die Raumtemperatur. Ein Vorheizen der Gase/der Gasmischung unterhalb der Abscheidetemperatur (zulässige Substrattemperatur) erhöht die Aufwuchsrate. Es sei noch angemerkt, dass die Indiumsulfidschicht auch Chlor (In₂(SₓCl_{2y})₃ mit x+y=1) enthält, das sich aber auf die Qualität der hergestellten Schicht, insbesondere auch bei deren Einsatz als Pufferschicht in einer Solarzelle, nicht nachteilig auswirkt.

### BEZUGSZEICHENLISTE

- **APCVD-R**: CVD-Reaktor bei Atmosphärendruck
- **DV**: Dosierventil
- **PR_{H2S(g)}**: erster Precursor (Schwefelwasserstoffgas H₂S)
- **PR_{In(g/fl)}**: zweiter Precursor (Indium enthaltend)
- **g**: gasförmig
- **fl**: flüssig
- **f**: fest
- **IG**: Inertgasstrom
- **MPR**: Mischprecusor
- **MP**: Mischgebiet
- **RPR**: Umgebungsdruck
- **RTE**: Umgebungstemperatur
- **SU**: Substrat
- **T**: Temperatur
- **RP**: Reaktionsgebiet
- **UPR**: nicht abgeschiedene Reaktionsprodukte

### ZITIERTE LITERATUR

**ALLSOP 2006**
   N.A. Allsop et al.: "Indium Sulfide Thin Films Deposited by the Spray Ion Layer Gas Reaction Technique", Thin Solid Films 513 (2006) 52-56
**TAKAHASHI 1 997**
   N. Takahashi et al.: "Growth of InN at High Temperature by Halide Vapor Epitaxy", Jpn. J. Appl. Phys. Vol.36 (1997) pp. L 743-L745
**DIEHL 1975**
   R. Diehl et al.: "Vapor Growth of Three In2S3 Modifications by lodine Transport" J. of Cryst. Growth 28 (1975) 306-310
**SAWADA 2002**
   Y. Sawada et al.: "Highly-Conducting Indium-Tin-Oxide Transparent Films fabricated by Spray CVD Using Ethanol Solution of Indium (III) Chloride ant Tin (II) Chloride" Thin Solid Films 409 (2002) 46-50
**ERNITS 2007**
   K. Ernits et al.: "Characterisation of Ultrasonically Sprayed InxSy Buffer layers for Cu(In,Ga)Se2 Solar Cells" Thin Solid Films 515 (2007) 6051-6054
**ASIKAINEN 1994**
   T. Asikainen et al.: "Growth of In2S3 Thin Films by Atomic Layer Epitaxy" Appl. Surface Science 82/83 (1994) 122-125
**NAGHAVI 2003**
   N. Naghavi et al: "High Efficiency Copper Indium Gallium Diselenide (CIGS) Solar Cells with Indium Sulfide Buffer Layers Deposited by Atomic Layer Chemical Vapor Deposition (ALCVD)" Prog. Photovolt: Res. Appl. 2003; 11:437-443
**AFZAAL 2003**
   Afzaal et al.: "Metal-Organic Chemical Vapor Deposition of β-In2S3 Thin Films Using a Single-Source Approach" J. of Mat. Sc.: Mat. in Electr. 14 (2003) 555-557
**BARONE 2001**
   Barone et al.: "Deposition of Tin Sulfide Thin Films from Tin(IV) Thiolate Precursors" J.Mater. Chem., 2001, 11, 464-468
**PARKIN 2001**
   Parkin et al.: "The First Single Source Deposition of Tin Sulfide Coatings on Glass: Aerosol-Assisted Chemical Vapor Deposition using [Sn(SCH2CH2S)2] J. Mater. Chem., 2001, 11, 1486-1490
**MOLLOY 2001**
   K.C. Molloy et al.: "New Precursors for the Chemical Vapour Deposition of Tin Sulphide Semiconductors and Related Materials" EPSRC Reference GR/L56442/01 und GR/L54721/01, 2001

## Patentansprüche

1. Chemisches Gasphasenabscheide-Verfahren unter Atmosphärendruck (APCVD) zur Herstellung einer n-halbleitenden Metallsulfid-Dünnschicht auf einem beheizten Substrat mit einem das Metall enthaltenden Precursor und Schwefelwasserstoff (H₂S) als reaktivem, gasförmigem Precursor und einem inerten Trägergasstrom,
**DADURCH GEKENNZEICHNET, DASS**
zur Herstellung einer kompakten Indiumsulfid-Dünnschicht (In₂S₃) ein Indium enthaltender Precursor (PR_{In(g/fl)}), der selbst einen hohen Dampfdruck besitzt oder mit einem Lösungsmittel ein flüchtiges Addukt bildet, in eine flüssige oder gasförmige Phase überführt, mit dem inerten Trägergasstrom (IG) und mit dem Schwefelwasserstoff (PR_{H2S(g)}), der in einer solchen Menge zugeführt wird, dass sich eine absolute Konzentration des Schwefelwasserstoffs (H₂S) gleich oder weniger als 1 Vol% in einem Mischgebiet (MP) ergibt, gemischt und auf das auf eine Temperatur (T) mit 100°C ≤ T ≤ 275°C aufgeheizte Substrat (SU) gelenkt wird, wobei die In-Konzentration des Indium enthaltenden Precursors (PR_{In(g/fl)}) so gewählt wird, dass die herzustellende Indiumsulfid- Dünnschicht (In₂S₃) kompakt ist.

2. Verfahren nach Anspruch 1,
**DADURCH GEKENNZEICHNET, DASS**
das Substrat (SU) laminar überströmt wird.

3. APCVD nach Anspruch 1,
**DADURCH GEKENNZEICHNET, DASS**
der Indium enthaltende Precursor (PR_{In(fl)}) in eine flüssige Phase überführt wird durch Auflösen in einem Lösungsmittel und Zerstäubung der Lösung mit einem Ultraschallgenerator oder pneumatischen Zerstäuber zur Erzeugung eines Aerosols aus feinsten Tropfen.

4. APCVD nach Anspruch 1,
**DADURCH GEKENNZEICHNET, DASS**
der Indium enthaltende Precursor (PR_{In(g)}) in eine gasförmige Phase überführt wird durch Überleiten eines Lösungsmitteldampfes über den Indium enthaltenden festen Precursor PR_{In(f)}).

5. APCVD nach Anspruch 1,
**DADURCH GEKENNZEICHNET, DASS**
der Indium enthaltende Precursor (PR_{In(g)}) in eine gasförmige Phase überführt wird durch Auflösen in einem Lösungsmittel und Auftropfen der Lösung auf eine erwärmte Fläche.

6. APCVD nach Anspruch 1,
**DADURCH GEKENNZEICHNET, DASS**
der Indium enthaltende Precursor (PR_{In(g/fl)}) ein Halogenidsalz des Indiums oder dessen Lösungsmitteladdukt ist.

7. APCVD nach Anspruch 6,
**DADURCH GEKENNZEICHNET, DASS**
das Halogenidsalz InCl₃ ist.

8. APCVD nach Anspruch 1,
**DADURCH GEKENNZEICHNET, DASS**
der Indium enthaltende Precursor (PR_{In(g/fl)}) ein β-Diketonat ist.

9. APCVD nach Anspruch 8,
**DADURCH GEKENNZEICHNET, DASS**
das β-Diketonat Indium-Acetylacetonat (In(acac)₃) ist.

10. APCVD nach Anspruch 1,
**DADURCH GEKENNZEICHNET, DASS**
das Lösungsmittel ein Alkohol oder ein Keton ist.

11. APCVD nach Anspruch 10,
**DADURCH GEKENNZEICHNET, DASS**
das Lösungsmittel Ethanol oder Aceton ist.

12. APCVD nach Anspruch 1,
**DADURCH GEKENNZEICHNET, DASS**
der Trägergasstrom (IG) N₂ ist.

13. APCVD nach Anspruch 1,
**DADURCH GEKENNZEICHNET, DASS**
das in der Umgebung des geheizten Substrats (SU) Raumtemperatur (RTE) herrscht.

14. APCVD nach Anspruch 1,
**DADURCH GEKENNZEICHNET, DASS**
der Schwefelwasserstoff (H₂S) oder die Mischung (MPR) aus dem Schwefelwasserstoff (H₂S) und dem Trägergasstrom (IG) vorgeheizt wird.

## Claims

1. A chemical vapor-phase deposition method under atmospheric pressure (APCVD) for producing an n-type semiconducting metal sulfide thin layer on a heated substrate with a precursor containing the metal and with hydrogen sulfide (H₂S) as the reactive gaseous precursor and an inert carrier gas stream,
**characterized in that**
a precursor containing indium (PR_{In(g/fl)}), which itself has a high vapor pressure or forms a liquid adduct with a solvent, is converted to a liquid or gaseous phase to produce a compact thin layer of indium sulfide (In₂S₃), then is mixed with the inert carrier gas stream (IG) and with the hydrogen sulfide (PR_{H2S(g)}), which is supplied in an amount sufficient to yield an absolute concentration of the hydrogen sulfide (H₂S) equal to or less than 1 vol% in a mixed region (MP) and which is deflected onto a substrate (SU) heated to a temperature (T) at 100°C ≤ T ≤ 275°C, such that the indium concentration of the indium-containing precursor (PR_{In(g)/fl)}) is selected so that the indium sulfide thin layer (In₂S₃) is compact.

2. The method according to Claim 1,
**characterized in that**
the flow passes over the substrate (SU) in a laminar flow.

3. The APCVD according to Claim 1,
**characterized in that**
the precursor containing indium (PR_{In(fl)}) is converted to a liquid phase by dissolving it in a solvent and atomizing the solution using an ultrasonic generator or a pneumatic atomizer to generate an aerosol from extremely fine droplets.

4. The APCVD according to Claim 1,
**characterized in that**
the indium-containing precursor (PR_{In(g)}) is converted to a vapor phase by passing a solvent vapor over the indium-containing solid precursor (PR_{In(f)}).

5. The APCVD according to Claim 1,
**characterized in that**
the indium-containing precursor (PR_{In(g)}) is converted to a gaseous phase by dissolving it in a solvent and by dripping the solution onto a heated surface.

6. The APCVD according to Claim 1,
**characterized in that**
the indium-containing precursor (PR_{In(g/fl)}) is a halide salt of indium or its solvent adduct.

7. The APCVD according to Claim 6,
**characterized in that**
the halide salt is InCl₃.

8. The APCVD according to Claim 1,
**characterized in that**
the indium-containing precursor (PR_{In(g/fl)}) is a β-diketonate.

9. The APCVD according to Claim 8,
**characterized in that**
the β-diketonate is indium acetylacetonate (In(acac)₃).

10. The APCVD according to Claim 1,
**characterized in that**
the solvent is an alcohol or a ketone.

11. The APCVD according to Claim 10,
**characterized in that**
the solvent is ethanol or acetone.

12. The APCVD according to Claim 1,
**characterized in that**
the carrier gas stream (IG) is N₂.

13. The APCVD according to Claim 1,
**characterized in that**
room temperature (RTE) prevails in the environment of the heated substrate (SU).

14. The APCVD according to Claim 1,
**characterized in that**
the hydrogen sulfide (H₂S) or the mixture (MPR) of the hydrogen sulfide (H₂S) and the carrier gas stream (IG) is preheated.

## Revendications

1. Procédé de dépôt chimique en phase gazeuse sous pression atmosphérique (APCVD) pour la production d'une couche mince de sulfure métallique n semiconductrice sur un substrat chauffé avec un précurseur contenant le métal et de l'acide sulfhydrique (H₂S) en tant que précurseur réactif gazeux et un flux de gaz porteur inerte,
**caractérisé en ce que**
pour la production d'une couche mince en sulfure d'indium (In₂S₃), on transfère dans une phase liquide ou gazeuse un précurseur (PR_{In(g/fl)}) qui fait lui-même preuve d'une pression élevée en vapeur ou qui avec un solvant forme un produit d'addition volatil, on le mélange avec le flux de gaz porteur inerte (IG) et avec l'acide sulfhydrique (PR_{H2S(g)}) qui est alimenté en une quantité telle, qu'il en résulte une concentration absolue de l'acide sulfhydrique (H₂S) inférieure ou égale à 1 % en volume dans une zone de mélange (MP) et on le dirige sur un substrat (SU) chauffé à une température (T), avec 100°C ≤ T ≤ 275°C, la concentration par ajout du précurseur contenant de l'indium (PR_{In(g/fl)}) étant choisie de sorte que la couche mince en sulfure d'indium (In₂S₃) qui doit être produite soit compacte.

2. Procédé selon la revendication 1,
**caractérisé en ce qu'**
on submerge le substrat (SU) de façon laminaire.

3. APCVD selon la revendication 1,
**caractérisé en ce qu'**
on transfère le précurseur contenant de l'indium (PR_{In}(_{fl)}) dans une phase liquide, par dissolution dans un solvant et pulvérisation de la solution avec un générateur d'ultrasons ou un pulvérisateur pneumatique pour la création d'un aérosol en gouttes d'extrême finesse.

4. APCVD selon la revendication 1,
**caractérisé en ce qu'**
on transfère le précurseur contenant de l'indium (PR_{In(g)}) dans une phase gazeuse par passage d'une vapeur de solvant sur le précurseur contenant de l'indium (PR_{In(f)}).

5. APCVD selon la revendication 1,
**caractérisé en ce qu'**
on transfère le précurseur contenant de l'indium (PR_{In(g)}) dans une phase gazeuse par dissolution dans un solvant et application de gouttes de la solution sur une surface échauffée.

6. APCVD selon la revendication 1,
**caractérisé en ce que**
le précurseur contenant de l'indium (PR_{In(g/fl)}) est un sel d'halogénure de l'indium ou son produit d'addition en solvant.

7. APCVD selon la revendication 6,
**caractérisé en ce que**
le sel d'halogénure est de l'InCl₃.

8. APCVD selon la revendication 1,
**caractérisé en ce que**
le précurseur contenant de l'indium (PR_{In(g/fl)}) est un β-dicétonate.

9. APCVD selon la revendication 8,
**caractérisé en ce que**
le β-dicétonate est un acétylacétonate d'indium (In(acac)₃)

10. APCVD selon la revendication 1,
**caractérisé en ce que**
le solvant est un alcool ou une cétone.

11. APCVD selon la revendication 10,
**caractérisé en ce que**
le solvant est de l'éthanol ou de l'acétone.

12. APCVD selon la revendication 1,
**caractérisé en ce que**
le flux de gaz porteur (IG) est du N₂.

13. APCVD selon la revendication 1,
**caractérisé en ce que**
dans l'environnement du substrat chauffé (SU), il règne une température ambiante (RTE).

14. APCVD selon la revendication 1,
**caractérisé en ce qu'**
on préchauffe l'acide sulfhydrique (H₂S) ou le mélange (MPR) de l'acide sulfhydrique (H₂S) et du flux de gaz porteur (IG).
